**Europäisches Patentamt**

**European Patent Office**

**Office européen des brevets**

(11) Veröffentlichungsnummer: **0 189 061**
**B1**

(12) # EUROPÄISCHE PATENTSCHRIFT

(45) Veröffentlichungstag der Patentschrift:
14.12.88

(21) Anmeldenummer: 86100209.5

(22) Anmeldetag: 09.01.86

(51) Int. Cl.⁴: **H 02 B 1/02**

(54) **Vorrichtung zum Verbinden von anreihbaren Schaltschränken.**

(30) Priorität: 24.01.85 DE 8501810 U

(43) Veröffentlichungstag der Anmeldung:
30.07.86 Patentblatt 86/31

(45) Bekanntmachung des Hinweises auf die Patenterteilung:
14.12.88 Patentblatt 88/50

(84) Benannte Vertragsstaaten:
**DE FR GB NL SE**

(56) Entgegenhaltungen:
**DE-A-2 504 721**
**DE-A-2 906 088**
**DE-C-3 344 598**

(73) Patentinhaber: **Rittal- Werk Rudolf Loh GmbH &
Co. KG, Auf dem Stützelberg, D-6348 Herborn (DE)**

(72) Erfinder: **Zachrai, Jürgen, Am Hungersberg 2,
D-6341 Dillenburg 8-Nanzenbach (DE)**

(74) Vertreter: **Vogel, Georg, Hermann- Essig- Strasse
35, D-7141 Schwieberdingen (DE)**

## Beschreibung

Die Erfindung betrifft eine Vorrichtung zum Verbinden von anreihbaren Schaltschränken, die aus Rahmenschenkeln zusammengesetzte Rahmengestelle aufweisen und zu den Verbindungsebenen hin Verbindungsrahmen bilden, wobei die Rahmenschenkel aus Hohlprofilabschnitten bestehen, die zumindest in den an die Innenkanten der Rahmengestelle anschließenden Profilwänden mit Lochreihen versehen sind.

Schaltschränke mit derartigen Rahmengestellen sind aus der DE-C-3 344 598 bekannt. Die direkte Verschraubung der Verbindungsrahmen im Bereich der Verbindungsebene ist bei diesen Schaltschränken praktisch nicht durchführbar, da die Verbindungsrahmen mit als Dichtungsstege verwendeten Profilteilen aneinander anliegen, die nach der Anreihung der Schaltschränke nicht mehr zugänglich sind.

Es ist Aufgabe der Erfindung, eine Vorrichtung der eingangs erwähnten Art zu schaffen, mit der auf einfache Weise die aneinander anliegenden Rahmenschenkel der Verbindungsrahmen benachbarter Schaltschränke an beliebigen Stellen miteinander verbunden werden können.

Diese Aufgabe wird nach der Erfindung dadurch gelöst, daß mindestens auf zwei einander gegenüberliegenden Seiten der Verbindungsrahmen jeweils die beiden aneinander anliegenden Rahmenschenkel der Verbindungsrahmen benachbarter Schaltschränke mittels einer Spannverbindung aus einem Spannschieber und zwei spiegelbildlichen Spannwinkeln miteinander verbunden sind, wobei die Spannwinkel über die Lochreihen an den in einer Ebene und senkrecht zur Verbindungsebene stehenden inneren Profilwänden der Rahmenschenkel befestigt sind, die abstehenden Spannschenkel der Spannwinkel im spitzen Winkel zu ihren Befestigungsschenkeln stehen und gegeneinander gerichtet eine Art sich konisch erweiternde Schwalbenschwanzfeder begrenzen und wobei der bügelförmig ausgebildete Spannschieber mit seinen Seitenschenkeln eine entsprechende, auf diese Schwalbenschwanzfeder abgestimmte, sich konisch verjüngende Schwalbenschwanznut bildet.

Bei dieser Vorrichtung erfolgt die Verbindung außerhalb der aneinander anliegenden Profilteile. Da sich die Lochreihen über die gesamte Länge der Rahmenschenkel erstrecken, kann die Spannverbindung an beliebigen Stellen angebracht werden. Außerdem ist es möglich, zwei benachbarte Rahmenschenkel auch über zwei und mehr Spannverbindungen miteinander zu verbinden. Beim Aufschieben des Spannschiebers auf die beiden mit den benachbarten Rahmenschenkeln verbundenen Spannwinkel werden die Rahmenschenkel zusätzlich gegeneinander verspannt und nach Arretierung des Spannschiebers in der Spannstellung auch in dieser verspannten Stellung festgehalten.

Die Anbringung der Spannwinkel an den Rahmenschenkeln ist nach einer Ausgestaltung so gelöst, daß die Lochreihen der Profilwände durch Bohrungen in vorgegebener Teilung gebildet sind, daß die Befestigungsschenkel der Spannwinkel jeweils zwei oder mehr Befestigungsbohrungen im Abstand dieser Teilung aufweisen, daß die Verbindungslinien der Befestigungsbohrungen der Spannwinkel im gleichen spitzen Winkel zu dem jeweils zugeordneten Spannschenkel verlaufen und daß die Spannwinkel mittels Blechschrauben, die in die Befestigungsbohrungen der Spannwinkel eingeführt und in Bohrungen der Profilwände eingeschraubt sind, an den Rahmenschenkeln befestigt sind.

Der Aufwand an Blechschrauben kann nach einer weiteren Ausgestaltung dadurch reduziert werden, daß die Lochreihen der Profilwände durch Vierkantdurchbrüche in vorgegebener Teilung mit jeweils einer zwischen zwei Vierkantdurchbrüchen angeordneten Bohrung gebildet sind, daß die Befestigungsschenkel der Spannwinkel zwei ausgestanzte und ausgebogene Einhängehaken im Abstand dieser Teilung und dazwischen jeweils eine Befestigungsbohrung aufweisen, daß die Verbindungslinien der Einhängehaken und der Bohrung in den Befestigungsschenkeln der Spannwinkel im gleichen spitzen Winkel zu dem zugeordneten Spannschenkel der Spannwinkel verlaufen und daß die Spannwinkel mit den Einhängehaken in Vierkantdurchbrüche der Profilwände eingehängt und jeweils mit einer einzigen Blechschraube, die in die Befestigungsbohrung des Spannwinkels eingeführt und in eine Bohrung der Profilwände eingeschraubt ist, an den Rahmenschenkeln befestigt sind. In jedem Fall wird durch die Ausrichtung der Befestigungsbohrungen und Einhängehaken auf den zugeordneten Spannschenkel des Spannwinkels die Anpassung an die konische Form des Spannschiebers erreicht.

Für die Arretierung des auf die Spannwinkel aufgeschobenen Spannschiebers sieht eine Ausgestaltung vor, daß der Spannschieber am schmalen Ende mit einer abgewinkelten Abschlußwand versehen ist, daß die Befestigungswinkel der Spannwinkel an ihren breiteren Enden mit Ansätzen versehen sind und daß bei auf die Spannwinkel aufgeschobenem Spannschieber die Ansätze als Anschläge zur Festlegung der Spannstellung des Spannschiebers hochgebogen sind.

Ist vorgesehen, daß der Spannschieber mit zusätzlichen Befestigungsbohrungen versehen ist, dann kann die Spannstellung des Spannschiebers zusätzlich noch mit Feststellschrauben fixiert werden.

Damit der Spannschieber mit einem einfachen Stanz-Biege-Werkzeug hergestellt werden kann, sieht eine Ausgestaltung vor, daß die Seitenschenkel des Spannschiebers zum schmalen Ende des Spannschiebers hin mit Aussparungen versehen sind.

Die Erfindung wird anhand eines in den Zeichnungen dargestellten Ausführungsbeispiels näher erläutert. Es zeigt:

Fig. 1 eine Teilansicht von zwei aneinander anliegenden Rahmenschenkeln der Verbindungsrahmen benachbarter Schaltschränke, wobei auf den inneren, zur Verbindungsebene senkrechten Profilwänden aufeinander ausgerichtet die beiden spiegelbildlichen Spannwinkel befestigt sind,

Fig. 2 dieselbe Teilansicht mit teilweise auf die Spannwinkel aufgeschobenem Spannschieber und

Fig. 3 die Teilansicht mit dem in der Spannstellung arretierten Spannschieber.

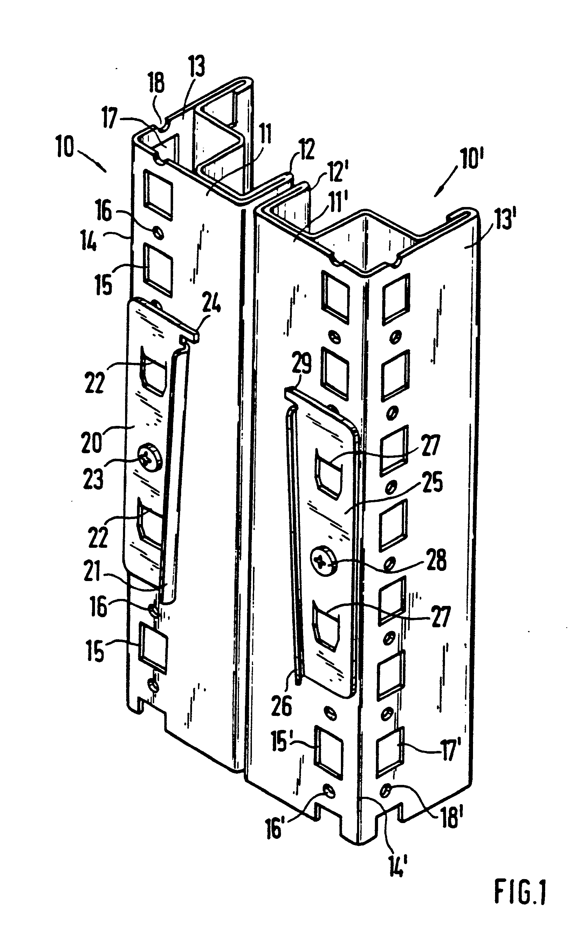

Die Schaltschränke weisen ein Rahmengestell auf, das jeweils aus zwölf Rahmenschenkeln zusammengesetzt ist. Die Rahmenschenkel sind Hohlprofilabschnitte, wie die Fig. 1 zeigt. Dabei sind alle Kanten 14 eines Rahmengestelles zum Innenraum des Schaltschrankes gerichtet. Von diesen Innenkanten 14 bzw. 14′ gehen die Profilwände 11 und 13 bzw. 11′ und 13′ aus, die senkrecht zueinander stehen und mit Lochreihen versehen sind. Die Profilwände 11 und 11′ sind zur Verbindungsebene hin verlängert und bilden L-förmige Dichtungsrahmen, die mit ihren Abschnitten 12 und 12′ in der Verbindungsebene aneinander anliegen. Auch die Profilwände 13 und 13′ der Rahmenschenkel 10 und 10′ der benachbarten Schaltschränke sind verlängert und bilden zur Vorder- bzw. Rückseite des Schaltschrankes einen umlaufenden Dichtungsrahmen. Die Abschnitte 12 und 12′ der aneinandergereihten Schaltschränke sind für eine direkte Verschraubung nicht zugänglich, wenn die Rückseite, die Decke und der Boden des Schaltschrankes mit Abdeckblechen verschlossen sind. Daher werden für die Verbindung der Schaltschränke die vom Innenraum des Schaltschrankes aus stets zugänglichen Profilwände 11 und 11′ der benachbarten Schaltschränke benützt.

Zumindest diese Profilwände 11 und 11′ tragen wie die Profilwände 13 und 13′ Lochreihen, die aus Vierkantdurchbrüchen 15 und 17 bzw. 15′ und 17′ in vorgegebener Teilung gebildet werden. Zwischen benachbarten Vierkantdurchbrüchen 15, 17, 15′ und 17′ sind jeweils Bohrungen 16, 18, 16′ und 18′ eingebracht. Auf die Profilwände 11 und 11′ der benachbarten Rahmenschenkel 10 und 10′ werden aufeinander ausgerichtet die spiegelbildlichen Spannwinkel 20 und 25 mit ihren Befestigungsschenkeln befestigt. Dazu tragen die Befestigungsschenkel zwei Einhängehaken 22 bzw. 27 in der vorgegebenen Teilung, die aus dem Befestigungsschenkel ausgestanzt und ausgebogen sind. Zwischen den Einhängehaken 22 bzw. 27 ist jeweils eine Befestigungsbohrung für eine Blechschraube 23 bzw. 28 eingebracht. Mit den beiden Einhängehaken 22 bzw. 27 wird der Spannwinkel 20 bzw. 25 in zwei Vierkantdurchbrüche 15 bzw. 15′ der Profilwand 11 bzw. 11′ eingehängt und mit der Blechschraube 23 bzw. 28 festgelegt, die in eine Bohrung 16 bzw. 16′ der Profilwand 11 bzw. 11′ eingeschraubt wird. Die Spannschenkel 21 und 26 der Spannwinkel 20 und 25 sind gegeneinander gerichtet und stehen im gleichen spitzen Winkel zu ihren zugeordneten Befestigungsschenkeln. Außerdem verlaufen die Spannschenkel 21 und 26 wieder in einem gleichen spitzen Winkel zu den zugeordneten Verbindungslinien der Einhängehaken 22 und 27 und der Befestigungsbohrungen. Damit bilden die beiden Spannschenkel 21 und 26 der an den Rahmenschenkeln 10 und 10′ befestigten Spannwinkel 20 und 25 eine Art Schwalbenschwanzfeder, die sich von einem zum anderen Ende der Spannwinkel 20 und 25 hin kontinuierlich verbreitert. Im Bereich des schmalen Endes der Schwalbenschwanzfeder tragen die Befestigungsschenkel der Spannwinkel 20 und 25 lappenförmig ausgestanzte Ansätze 24 und 29.

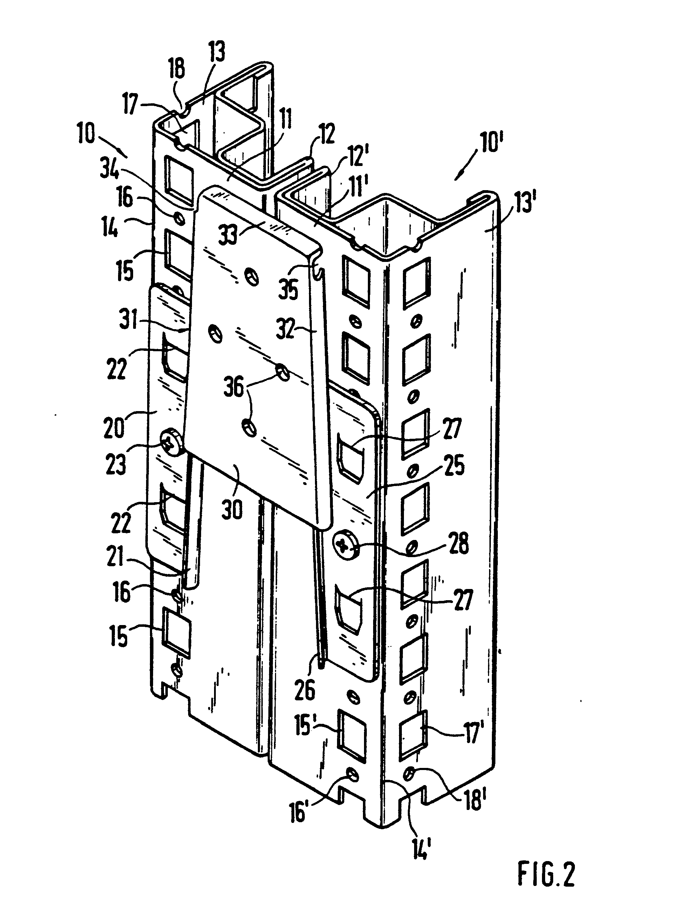

Zur Vervollständigung der Spannverbindung wird der Spannschieber 30 verwendet, der, wie die Fig. 2 zeigt, mit seiner breiten offenen Schmalseite auf die Spannschenkel 21 und 26 der Spannwinkel 20 und 25 aufgeschoben wird. Der Spannschieber 30 bildet mit seinen Seitenschenkeln 31 und 32 eine Schwalbenschwanznut, die auf die Schwalbenschwanzfeder abgestimmt ist. Die Seitenschenkel 31 und 32 stehen im gleichen Winkel zum plattenförmigen Mittelteil des Spannschiebers 30 wie die Spannschenkel 21 und 26 zu den Befestigungsschenkeln der Spannwinkel 20 und 25. Außerdem ist der Verjüngungswinkel des Spannschiebers 30 an die Neigung der Spannschenkel 21 und 26 zu den Verbindungslinien der Einhängehaken 22 und 27 angepaßt.

Die kürzere Schmalseite des Spannschiebers 30 ist durch die abgewinkelte Abschlußwand 33 verschlossen. Die Seitenschenkel 31 und 32 des Spannschiebers 30 sind vor der Abschlußwand 33 ausgespart, wie die Aussparungen 34 und 35 zeigen, damit der Spannschieber 30 mit einem einfachen Stanz-Biege-Werkzeug hergestellt werden kann.

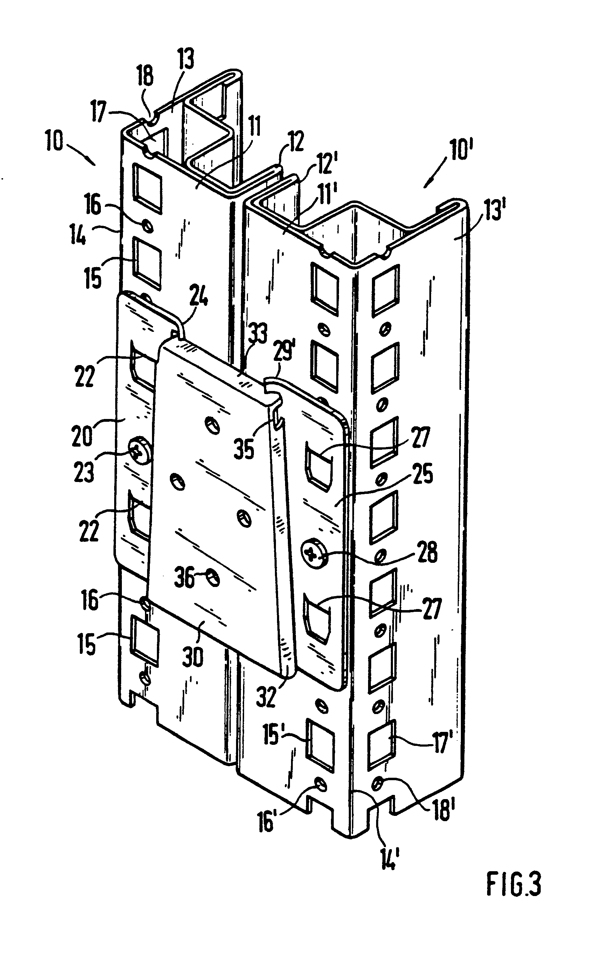

Ist, wie Fig. 3 zeigt, der Spannschieber 30 auf die durch die Spannschenkel 21 und 26 der Spannwinkel 20 und 25 gebildete Schwalbenschwanzfeder voll aufgeschoben, dann sind die Rahmenschenkel 10 und 10′ fest gegeneinander verspannt. Die Spannstellung des Spannschiebers 30 wird dadurch gesichert, daß die Ansätze 24 und 29 der Spannwinkel 20 und 25 als Anschläge 24′ und 29′ hochgebogen werden. Der Spannschieber 30 trägt im plattenförmigen Teil zusätzliche Befestigungsbohrungen 36, die für eine weitere Verschraubung ausgenützt werden können.

Es ist einleuchtend, daß die aufeinander stoßenden Verbindungsrahmen benachbarter Schaltschränke zumindest an zwei einander gegenüberliegenden Seiten mindestens durch eine derartige Spannverbindung miteinander verbunden werden müssen. Es lassen sich jedoch auch mehr als eine Spannverbindung zum Verbinden aneinander anliegender Rahmenschenkel der Verbindungsrahmen verwenden. Die Spannverbindungen können dabei an verschiedenen, durch die Teilung der Vierkantdurchbrüche vorgegebenen Stellungen angebracht werden, wobei diese Spannverbindungen auch auf alle vier Rahmenschenkel der Verbindungsrahmen verteilt sein können.

**Patentansprüche**

1. Vorrichtung zum Verbinden von anreihbaren Schaltschränken, die aus Rahmenschenkeln (10, 10') zusammengesetzte Rahmengestelle aufweisen und zu den Verbindungsebenen hin Verbindungsrahmen bilden, wobei die Rahmenschenkel (10, 10') aus Hohlprofilabschnitten bestehen, die zumindest in den an die Innenkanten (14, 14') der Rahmengestelle anschließenden Profilwänden (11, 11') mit Lochreihen versehen sind,
dadurch gekennzeichnet,
daß mindestens auf zwei einander gegenüberliegenden Seiten der Verbindungsrahmen jeweils die beiden aneinander anliegenden Rahmenschenkel (10, 10') der Verbindungsrahmen benachbarter Schaltschränke mittels einer Spannverbindung aus einem Spannschieber (30) und zwei spiegelbildlichen Spannwinkeln (20, 25) miteinander verbunden sind, wobei die Spannwinkel (20, 25) über die Lochreihen (15, 16) an den in einer Ebene und senkrecht zur Verbindungsebene stehenden inneren Profilwänden (11, 11') der Rahmenschenkel (10, 10') befestigt sind, die abstehenden Spannschenkel (21, 26) der Spannwinkel (20, 25) im spitzen Winkel zu ihren Befestigungsschenkeln stehen und gegeneinander gerichtet eine Art sich konisch erweiternde Schwalbenschwanzfeder begrenzen und wobei der bügelförmig ausgebildete Spannschieber (30) mit seinen Seitenschenkeln (31, 32) eine entsprechende, auf diese Schwalbenschwanzfeder abgestimmte, sich konisch verjüngende Schwalbenschwanznut bildet.
2. Vorrichtung nach Anspruch 1,
dadurch gekennzeichnet,
daß die Lochreihen (16) der Profilwände (11, 11') durch Bohrungen in vorgegebener Teilung gebildet sind, daß die Befestigungsschenkel der Spannwinkel (20, 25) jeweils zwei oder mehr Befestigungsbohrungen im Abstand dieser Teilung aufweisen,

daß die Verbindungslinien der Befestigungsbohrungen der Spannwinkel (20, 25) im gleichen spitzen Winkel zu dem jeweils zugeordneten Spannschenkel (21, 26) verlaufen und
daß die Spannwinkel (20, 25) mittels Blechschrauben, die in die Befestigungsbohrungen der Spannwinkel (20, 25) eingeführt und in Bohrungen der Profilwände (11, 11') eingeschraubt sind, an den Rahmenschenkeln (10, 10') befestigt sind.
3. Vorrichtung nach Anspruch 1,
dadurch gekennzeichnet,
daß die Lochreihen (15, 16) der Profilwände (11, 11') durch Vierkantdurchbrüche in vorgegebener Teilung mit jeweils einer zwischen zwei Vierkantdurchbrüchen angeordneten Bohrung gebildet sind,
daß die Befestigungsschenkel der Spannwinkel (20, 25) zwei ausgestanzte und ausgebogene Einhängehaken (22, 27) im Abstand dieser Teilung und dazwischen jeweils eine Befestigungsbohrung aufweisen,
daß die Verbindungslinien der Einhängehaken und der Bohrung in den Befestigungsschenkeln der Spannwinkel (20, 25) im gleichen spitzen Winkel zu dem zugeordneten Spannschenkel (21, 26) der Spannwinkel (20, 25) verlaufen und
daß die Spannwinkel (20, 25) mit den Einhängehaken (22, 27) in Vierkantdurchbrüche (15) der Profilwände (11, 11') eingehängt und jeweils mit einer einzigen Blechschraube (23, 2), die in die Befestigungsbohrung des Spannwinkels (20, 25) eingeführt und in eine Bohrung der Profilwände (11, 11') eingeschraubt ist, an den Rahmenschenkeln (10, 10') befestigt sind.
4. Vorrichtung nach einem der Ansprüche 1 bis 3,
dadurch gekennzeichnet,
daß der Spannschieber (20) am schmalen Ende mit einer abgewinkelten Abschlußwand (33) versehen ist,
daß die Befestigungsschenkel der Spannwinkel (20, 25) an ihren breiteren Enden mit Ansätzen (24, 29) versehen sind und
daß bei auf die Spannwinkel (20, 25) aufgeschobenem Spannschieber (30) die Ansätze (24, 29) als Anschläge zur Festlegung der Spannstellung des Spannschiebers (30) hochgebogen sind.
5. Vorrichtung nach einem der Ansprüche 1 bis 4,
dadurch gekennzeichnet,
daß die Seitenschenkel (31, 32) des Spannschiebers (30) zum schmalen Ende des Spannschiebers (30) hin mit Aussparungen (34, 35) versehen sind.
6. Vorrichtung nach einem der Ansprüche 1 bis 5,
dadurch gekennzeichnet,
daß der Spannschieber (30) mit zusätzlichen Befestigungsbohrungen (36) versehen ist.

## Claims

1. Device for joining together attachable control cabinets exhibiting assembled frameworks of frame limbs (10, 10') and form connecting frames to the connecting planes, whereby the frame limbs (10, 10') consist of hollow sections which at least in the profile walls (11, 11') adjoining the inside edges (14, 14') of the framework are provided with rows of holes, characterised in that at least on two opposite sides of the connecting frame the two adjacent frame limbs (10, 10') of the connecting frames of neighbouring control cabinets are joined together by means of a locking slider (30) and two mirrored locking brackets (20, 25), whereby the locking brackets (20, 25) are fixed via the rows of holes (15, 16) on the inside profile walls (11, 11') of the frame limbs (10, 10') which are plane and vertical to the connection plane, the projecting locking limbs (21, 26) of the locking brackets (20, 25) are at an acute angle to their mounting limbs and are set opposing each other defining a type of conically widening dovetail and whereby the bow-shaped tension slider (30) forms with its side limbs (31, 32) a corresponding conically tapering dovetail groove, adapted to this dovetail.

2. Device according to claim 1, characterised in that the rows of holes (16) of the profile walls (11, 11') are formed by bored holes with given spacing, that the mounting limbs of the locking brackets (20, 25) each show two or more mounting holes spaced at this distance, that the connecting lines of the mounting holes in the locking bracket (20, 25) run at the same acute angle to the associated locking limb (21, 27), and that the locking brackets (20, 25) are fixed to the frame limbs by means of tapping screws which are inserted through the mounting holes of the locking brackets (20, 25) and screwed into the bored holes in the profile walls (11, 11').

3. Device pursuant to claim 1, characterised in that the rows of holes (15, 16) of the profile walls are formed by square punchouts with given spacing with one bored hole positioned between each square punchout, that the mounting limbs of the locking brackets (20, 25) show two punched out and bentout clevis hooks (22, 27) spaced at this distance and in between each a bored hole, that the connecting lines of the clevis hook and the bored hole in the mounting limb of the locking bracket (20, 25) run at the same acute angle to the associated locking limb (21, 26) of the locking bracket (20, 25) and that the locking brackets (20, 25) hung with the clevis hooks (22, 27) into square punchouts (15) of the profile walls (11, 11') and each fixed on the frame limbs (10, 10') with a single tapping screw (23, 28), which is inserted through the mounting holes of the locking bracket (20, 25) and screwed into a bored hole in the profile walls (11, 11').

4. Device pursuant to one of the claims 1 to 3, characterised in that the locking slider (20) at the narrow end is provided with an angled end wall (33), that the mounting limbs on the locking brackets (20, 25) are fitted with tongues (24, 29) at their wider ends and that with the locking slider (30) pushed up on the locking brackets, the tongues (24, 29) are bent up as stops for definition of the locking point of the locking slider.

5. Device pursuant to one of the claims 1 to 4, characterised in that the side slimbs (31, 32) of the locking slider (30) are provided with recesses (34, 35) towards the narrow end of the locking slider (30).

6. Device pursuant to one of the claims 1 to 5, characterised in that the locking slider (30) is foreseen with additional mounting bore holes.

## Revendications

1. Dispositif déstiné à relier des armoires de commande modulaires ayant des châssis de cadres composés de branches de cadre (10, 10') et composant des cadres de jonction vers les niveaux de jonction, les branches (10, 10') étant fabriquées de sections de profilé creux qui sont munies de trous au moins dans les parois de profilé (11, 11') situés à côté des bords intérieurs (14, 14') des châssis de cadre, caractérisé en ce qu'au moins des deux faces opposées des cadres de jontion les branches de cadres adjacentes (10, 10') du châssis des armoires adjacentes sont reliés l'une à l'autre au moyen d'un dispositif de serrage comprenant un tiroir de serrage (30) et deux équerres réfléchies (20, 25), les équerres (20, 25) étant fixées par intermédiaire des rangées de trous (15, 16) aux parois intérieurs de profilé (11, 11') des branches (10, 10') se trouvant à un même niveau et étant vertical au niveau de fixation, et les branches (21, 26) des équerres de serrage (20, 25) étant situé en angle de pointe relatif à ses branches de fixation et formant, opposée l'une à l'autre, une sorte de queue de hirondelle, et le tiroir de serrage (30) en forme d'étrier formant avec ses branches latérales (31, 32) une rainure correspondante à cette forme de queue d'hirondelle se réduisant coniquement.

2. Dispositif selon la revendication 1, caractérisé en ce que les rangées de trous (16) des parois en profilé (11, 11') sont formées par des alésages à un certain pas, que les branches de fixation des équerres de serrage (20, 25) sont munies de deux ou plus d'alésages à ce même pas, que les lignes de liaison des alésages de fixation des équerres (20, 25) sont situées au même angle de pointe vers la branche de serrage correspondante (21, 26), et que les équerres de serrage (20, 25) sont fixés aux branches du cadre (10, 10') au moyen de vis à tôle qui sont introduites dans les trous de fixation des équerres de serrage (20, 25) et vissées dans les alésages des parois en profilé (11, 11').

3. Dispositif selon la revendication 1, caractérisé en ce que les rangées de trous (15, 16) des parois en profilé (11, 11') sont formées de trous rectangulaires à un pas donné avec un alésage entre deux trous rectangulaires, que les branches de fixation des équerres de serrage (20, 25) sont munies de deux crochets découpés (22, 27) à ce pas avec un alésage de fixation entre les deux crochets,

que les lignes de liaison entre crochet et alésage dans les branches de fixation des équerres de serrage (20, 25) sont situées au même angle de pointe à la branche de serrage (21, 26) correspondante des équerres de serrage (20, 25), et

que les équerres de serrage (20, 25) avec les crochets (22, 27) accrochés dans les trous rectangulaires (15) des parois en profilé (11, 11') sont fixées aux branches du châssis (10, 10') au moyen d'une seule vis à tôle (23, 28), qui est introduite dans l'alésage de fixation de l'équerre de serrage (20, 25) et vissée dans un alésage des parois en profilé (11, 11').

4. Dispositif selon une des revendications de 1 à 3, caractérisé en ce que le tiroir de serrage (20) est muni de son extrémité étroite d'un cloison (33) angulaire, que les branches de fixation des équerres de serrage (20, 25) sont munies de languettes (24, 29) de ses extrémités plus larges et

qu'avec le tiroir (30) monté sur les équerres de serrage (20, 25) les languettes sont pliées vers le haut servant ainsi de butées pour le tiroir de serrage (30) en position de serrage.

5. Dispositif selon une des revendications de 1 à 4, caractérisé en ce, que les branches latérales (31, 32) du tiroir de serrage (30) sont munies d'encoches du côté plus étroit du tiroir (30).

6. Dispositif selon une des revendication de 1 à 5, caractérisé en ce que le tiroir de serrage (30) est muni d'alésages supplémentaires de fixation (36).

FIG.1

FIG.2

FIG.3